# EUROPEAN PATENT APPLICATION

(11) **EP 4 220 695 A1**
(43) Date of publication of application: **02.08.2023**
(21) Application number: 21943195.4
(22) Date of filing: 14.10.2021
(51) Int. Cl.: H01L 21/67, H01L 21/304, H01L 21/68, B24B 9/06, B24B 49/12

(54) **METHOD, SYSTEM, AND APPARATUS FOR PROCESSING WAFER**

(30) Priority: 25.05.2021 KR 20210067263
(71) Applicant: Meere Company Inc., Hwaseong-si, Gyeonggi-do 18630 (KR)
(72) Inventor: JUNG, Il Jun, Pyeongtaek-si Gyeonggi-do 17720 (KR); KIM, Ki Ho, Osan-si Gyeonggi-do 18113 (KR); HAN, Jung Yul, Hwaseong-si Gyeonggi-do 18457 (KR); LEE, Ki Heon, Osan-si Gyeonggi-do 18111 (KR); PARK, Ji Hun, Hwaseong-si Gyeonggi-do 18500 (KR)
(74) Representative: AWA Sweden AB
(86) International application number: PCT/KR2021/014287
(87) International publication number: WO 2022/250208

(57) **Abstract**

An embodiment of the present disclosure provides a wafer processing method including preparing a wafer having a notch portion at one side thereof, aligning the wafer by analyzing image information of the notch portion captured by a vision camera, and processing the notch portion using a notch wheel so that a certain region of the notch portion has a preset thickness.

## Description

### Technical Field

Embodiments of the present disclosure relate to wafer processing methods, systems, and apparatus.

### Background Art

When device formation is completed, wafers undergo a back grinding process to reduce a thickness by working a lower surface thereof. Because wafers that have undergone the back grinding process become thinner, the number of stacked wafer layers may increase. This is connected to performance improvement of semiconductor.

However, in the related art case, the thickness of wafers becomes too thin during the back grinding process, resulting in damage to wafers. In particular, a notch portion formed for wafer alignment may be damaged during the back grinding process.

### Detailed Description of the disclosure

### Technical Problem

Embodiments of the present disclosure are intended to provide a wafer processing method, system, and device for preventing damage to a wafer during a back grinding process by processing a notch portion of a wafer.

### Technical Solution to Problem

An embodiment of the present disclosure provides a wafer processing method including preparing a wafer having a notch portion formed at one side, aligning the wafer, and processing the notch portion so that a certain region of the notch portion has a preset thickness using a notch wheel.

### Advantageous Effects of Disclosure

The wafer processing method, system, and device according to embodiments of the present disclosure process the notch portion of the wafer before a back grinding process, thereby preventing damage to the wafer that occurs during the back grinding process.

In addition, the wafer processing method, system, and device according to an embodiment of the present disclosure allow the center of a notch wheel to be located outside a wafer during processing of a notch portion, thereby performing stable and precise processing of the notch portion.

In addition, the wafer processing method, system, and device according to an embodiment of the present disclosure may prevent recognition errors by forming an inclined surface in a notch portion of a wafer and using the inclined surface as an alignment mark in a subsequent process.

### Brief Description of Drawings

FIG. 1 is a diagram schematically illustrating a wafer processing system according to an embodiment of the present disclosure.
FIG. 2 is a block diagram of the wafer processing system of FIG. 1.
FIG. 3 is a flowchart of a wafer processing method according to an embodiment of the present disclosure.
FIGS. 4A to 4B are diagrams illustrating a path of a nozzle for cleaning one surface of a wafer according to an embodiment of the present disclosure.
FIGS. 5A to 5B are diagrams illustrating a nozzle according to an embodiment of the present disclosure.
FIG. 6 is a diagram schematically illustrating a wafer as a processing target.
FIG. 7 is a diagram illustrating an alignment device.
FIG. 8 is a diagram illustrating a method of extracting edge information of a notch portion.
FIG. 9 is a diagram schematically illustrating a notch processing device according to an embodiment of the present disclosure.
FIG. 10 is a conceptual diagram illustrating a wafer processing method using the notch processing device of FIG. 9.
FIGS. 11A to 11C are diagrams illustrating a portion processed by a wafer processing method.
FIG. 12 is a conceptual diagram illustrating a wafer processing method using a notch processing device according to another embodiment.
FIGS. 13A to 13C are diagrams illustrating a portion processed by the wafer processing method of FIG. 12.
FIGS. 14A and 14B are diagrams illustrating a notch wheel according to another embodiment.
FIGS. 15A and 15B are diagrams illustrating a notch wheel according to another embodiment.
FIGS. 16 and 17 are diagrams illustrating an edge processing device according to an embodiment of the present disclosure.
FIGS. 18 to 20B are diagrams illustrating an edge processing method according to an embodiment of the present disclosure.
FIG. 21 is a diagram illustrating an automatic tool replacing device according to an embodiment of the present disclosure.
FIG. 22 is a diagram illustrating another embodiment of an automatic tool replacing device.
FIGS. 23 and 24 are diagrams illustrating an automatic tool replacing method according to an embodiment of the present disclosure.
FIG. 25 is a diagram illustrating an inspection device according to an embodiment of the present disclosure.

### Best Mode

An embodiment of the present disclosure provides a wafer processing method includingpreparing a wafer having a notch portion at one side thereof, aligning the wafer, and processing the notch portion using a notch wheel so that a certain region of the notch portion has a preset thickness.

In an embodiment of the present disclosure, the wafer processing method may further include analyzing image information of the notch portion and extracting edge information of the notch portion and setting a processing path of the notch wheel using the extracted edge information and previously planned notch processing information, wherein, in the processing of the notch portion, the notch portion is processed so that the certain region of the notch portion has the preset thickness by controlling the notch wheel to move the set processing path.

In an embodiment of the present disclosure, the wafer processing method may further include, before the processing of the notch portion, identifying whether an existing notch wheel is mounted at one end of a spindle, when the existing notch wheel is mounted, removing the existing notch wheel by moving the spindle to a preset zone, identifying whether the existing notch wheel is removed from one end of the spindle, and moving the spindle to a cassette unit storing a plurality of new notch wheels and mounting one of the plurality of new notch wheels at one end of the spindle, wherein, in the processing of the notch portion, the notch portion is processed so that the certain region of the notch portion has the preset thickness by moving the spindle on which the new notch wheel is mounted to the notch portion of the wafer.

In an embodiment of the present disclosure, the wafer processing method may further include, before the processing of the notch portion, determining whether to replace the existing notch wheel at one end of the spindle, when it is determined to replace the existing notch wheel, removing the existing notch wheel from the spindle and mounting a new notch wheel, measuring a first length from one end of the spindle to an end of the new notch wheel using a check sensor unit, and correcting processing position information of the existing notch wheel using the first length, wherein, in the processing of the notch portion, the notch portion is processed so that the certain region of the notch portion of the wafer has the preset thickness by controlling the new notch wheel according to the corrected processing position information.

In an embodiment of the present disclosure, the wafer processing method may further include supplying cleaning water by a wafer cleaning nozzle and cleaning the wafer, wherein the wafer cleaning nozzle includes a first nozzle tip including a gas inlet and a gas outlet and a second nozzle tip including a cleaning water inlet and a cleaning water outlet, and wherein the gas outlet communicates with cleaning water outlet.

An embodiment of the present disclosure provides a wafer processing system including a support table on which a wafer having a notch portion at one side is seated, an alignment device acquiring image information of the notch portion using a vision camera imaging the notch portion of the wafer seated on the support table and aligning the wafer by analyzing the acquired image information of the notch portion, and a notch processing device including a notch wheel processing the notch portion so that a certain region of the notch portion has a preset thickness and a spindle having one end at which the notch wheel is rotatably mounted.

In an embodiment of the present disclosure, the wafer processing system may further include a controller extracting edge information of the notch portion by analyzing the image information of the notch portion, setting a processing path of the notch wheel using the extracted edge information and previously planned notch processing information, and controlling the notch wheel to move along the set processing path.

In an embodiment of the present disclosure, the wafer processing system may further include an edge processing device including an edge wheel processing the portion of the wafer so that a certain region of the edge portion has a second thickness, and a second spindle having one end at which the edge wheel is mounted to be rotatable about a second rotation axis.

An embodiment of the present disclosure provides a wafer processing device including a notch wheel processing a notch portion of a wafer so that a certain region of the notch portion has a preset thickness and a spindle having one end at which the notch wheel is rotatably mounted.

In an embodiment of the present disclosure, a diameter of the notch wheel may be greater than a width of the certain region of the notch portion to be processed.

In an embodiment of the present disclosure, the notch wheel may include a slit portion formed to divide a processing portion of the notch wheel including a processing surface in contact with the wafer into two or more parts.

In an embodiment of the present disclosure, the notch wheel may include a first processing portion having a first diameter and a second processing portion having a second diameter smaller than the first diameter, located at one end of the first processing portion, and protruding outwardly from one end of the first processing portion.

In an embodiment of the present disclosure, the second processing portion may have a tapered surface inclined with respect to one end surface of the first processing portion.

Other aspects, features, and advantages than those described above will become apparent from the following drawings, claims and detailed description of the invention.

### Mode of Disclosure

Hereinafter, the following embodiments are described in detail with reference to the accompanying drawings, and when describing with reference to the drawings, the same or corresponding components are given the same reference numerals, and redundant description thereof are omitted.

The present embodiments may be variously modified, so specific embodiments are illustrated in the drawings and described in detail in the detailed description. Effects and characteristics of the present embodiments, and methods for achieving them are apparent with reference to the details described below in conjunction with the drawings. However, the present embodiments are not limited to the embodiments described below and may be implemented in various forms.

In the following embodiments, terms, such as first and second are used for the purpose of distinguishing one component from another component, rather than in a limiting sense.

In the following embodiments, singular expressions include plural expressions unless the context clearly indicates otherwise.

In the following embodiments, terms such as "including" or "having" means that the features or components described in the specification are present, and do not preclude the possibility that one or more other features or components are added.

In the following embodiments, it will be understood that when a portion, such as a unit, region, component, etc. is referred to as being on or above another portion, it may be directly on the other portion or intervening elements may also be present.

In the following embodiments, terms, such as "connect" or "couple" do not necessarily mean direct and/or fixed connection or coupling of two members unless the context clearly indicates otherwise, and does not exclude that another member is present between the two members.

Terms such as "including" or "having" means that the features or components described in the specification are present, and do not preclude the possibility that one or more other features or components will be added.

In the drawings, the size of components may be exaggerated or reduced for convenience of description. For example, the size and thickness of each component shown in the drawings are arbitrarily indicated for convenience of description, so the following embodiments are not limited thereto.

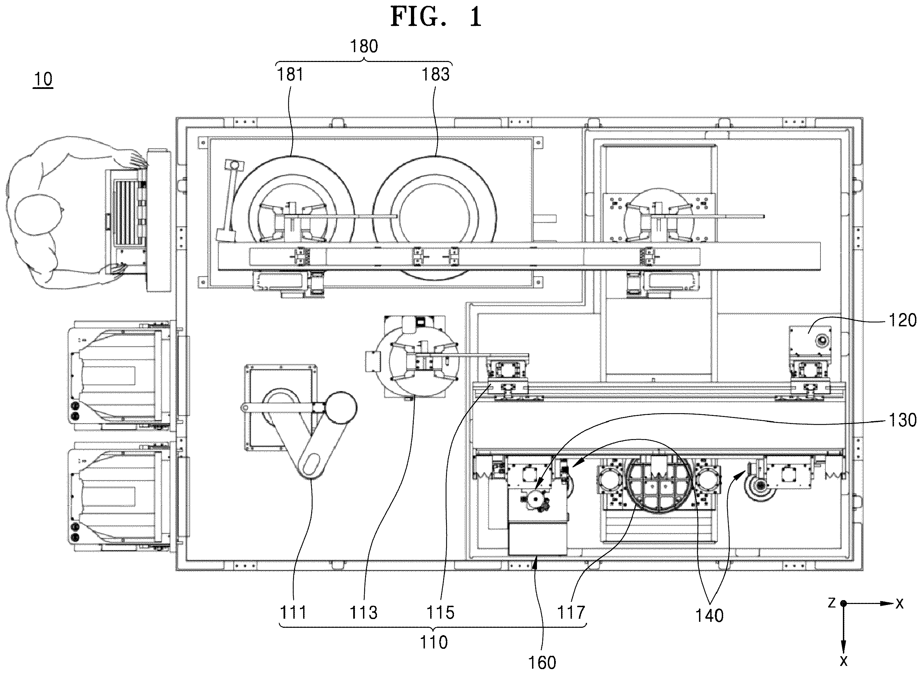

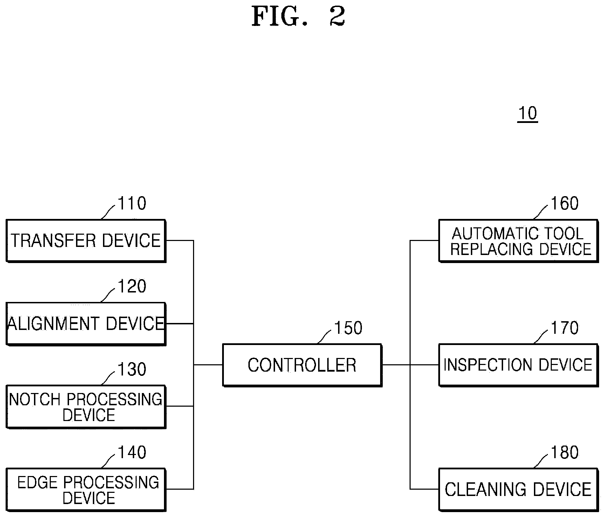

FIG. 1 is a schematic diagram of a wafer processing system 10 according to an embodiment of the present disclosure, and FIG. 2 is a block diagram of the wafer processing system 10 of FIG. 1.

Referring to FIGS. 1 and 2, the wafer processing system 10 according to an embodiment of the present disclosure relates to a system for processing a wafer, and more particularly, to a system for improving a process yield of a wafer by trimming or cutting a notch portion before a back grinding process of reducing a thickness of the wafer.

The wafer processing system 10 according to an embodiment of the present disclosure may include a transfer device 110, an alignment device 120, a notch processing device 130, an edge processing device 140, and a controller 150. In addition, the wafer processing system 10 may further include an automatic tool replacing device 160, an inspection device 170, and a cleaning device 180.

The transfer device 110 transfers a wafer W carried in from the outside to the notch processing device 130 or the edge processing device 140, and when the processing is completed, the transfer device 110 performs a function of carrying out the wafer W to the outside of the system 10 after a cleaning process.

The transfer device 110 may include a transfer robot 111, a pre-aligner 113, a picker 115 and a support table 117.

The transfer robot 111 performs a function of supporting a wafer carried in from the outside (or an in loader port) and transferring the wafer to the pre-aligner 113. In addition, the transfer robot 111 may perform a function of carrying out the processed wafer to the outside (or an out loader port) after the wafer is cleaned. The transfer robot 111 may have a structure for transferring wafers, and may include, for example, a robot arm structure having a plurality of degrees of freedom.

The wafer delivered by the transfer robot 111 may be primarily aligned by the pre-aligner 113 and then placed on the support table 117 through the picker 115. For example, the pre-aligner 113 may identify a position of a notch portion formed at one side of the wafer and align the wafer based on the notch portion. The pre-aligner 113 performs a function of primarily aligning the position of the wafer delivered by the transfer robot 111, and a more sophisticated aligning function may be performed through the alignment device 120.

The support table 117 serves to support the wafer during processing. The support table 117 may further include a separate fixing member (not shown) to stably support the wafer. For example, the support table 117 may adsorb and support the wafer using a plurality of adsorption holes (not shown). Alternatively, the support table 117 may mechanically support the wafer using a clamp (not shown).

The support table 117 may move or rotate the wafer in three dimensions, while supporting the wafer.

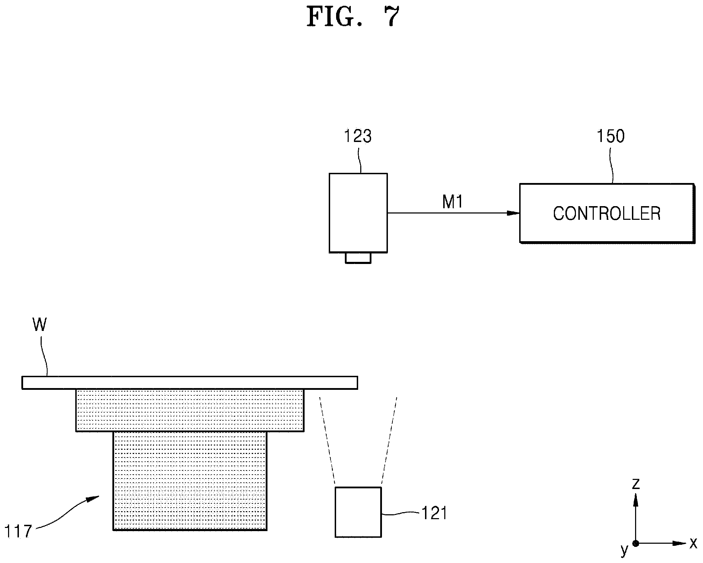

The alignment device 120 may acquire image information of the notch portion using a vision camera 123 (refer to FIG. 7). The alignment device 120 may further include a lighting unit 121 (refer to FIG. 7). That is, the alignment device 120 irradiates light toward the wafer using the lighting unit 121 (refer to FIG. 7) disposed below the wafer, and in this state, the alignment device 120 may acquire image information of the notch portion by the vision camera 123 (refer to FIG. 7).

In this case, a portion in which the wafer is present may block light to be expressed as being dark, and a portion in which the wafer is not present due to the formation of the notch portion may allow light to be transmitted therethrough and be expressed brightly. The image information of the notch portion acquired by the alignment device 120 may include edge line information of the notch portion distinguished through light and shade.

In addition, the alignment device 120 may measure a plurality of points on the wafer seated on the support table 117 using the vision camera 123 (refer to FIG. 7) and identify a deviation of a center point of the wafer from a rotation axis of the support table 117 in advance therethrough. Alternatively, the alignment device 120 may identify a position of the notch processing device 130 or the edge processing device 140 in advance using the vision camera 123 (refer to FIG. 7).

The notch processing device 130 may be located at one side of the wafer processing system 10 and may be movable toward the wafer seated on the support table 117. The notch processing device 130 may process the notch portion formed in the wafer to reduce a thickness of the notch portion (trimming) or cut (cutting) at least a portion of the notch portion.

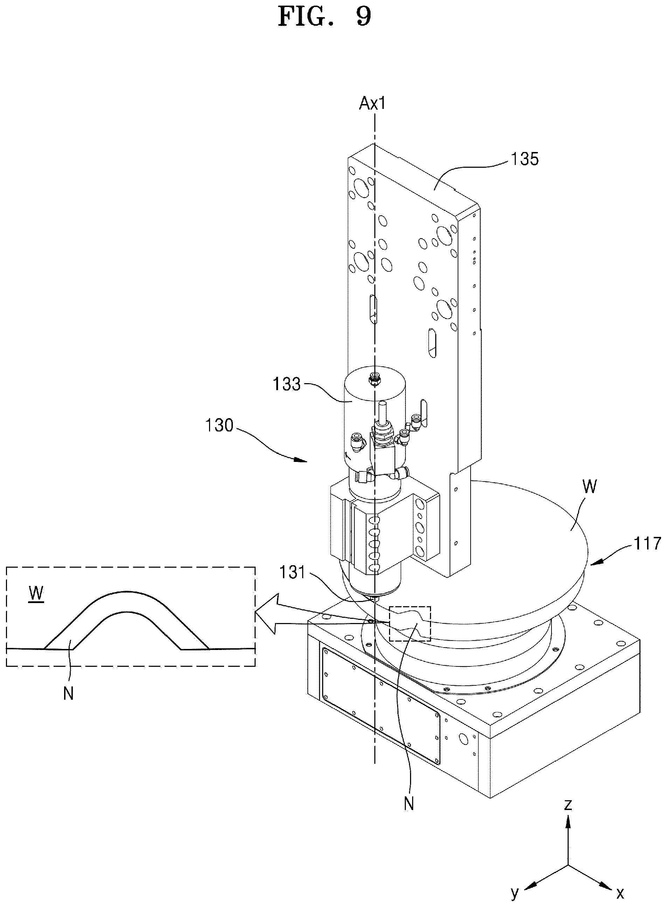

The notch processing device 130 may include a notch wheel 131 (refer to FIG. 9), a first spindle 133 (refer to FIG. 9), and a first support plate 135. A notch processing method of the notch processing device 130 is described below.

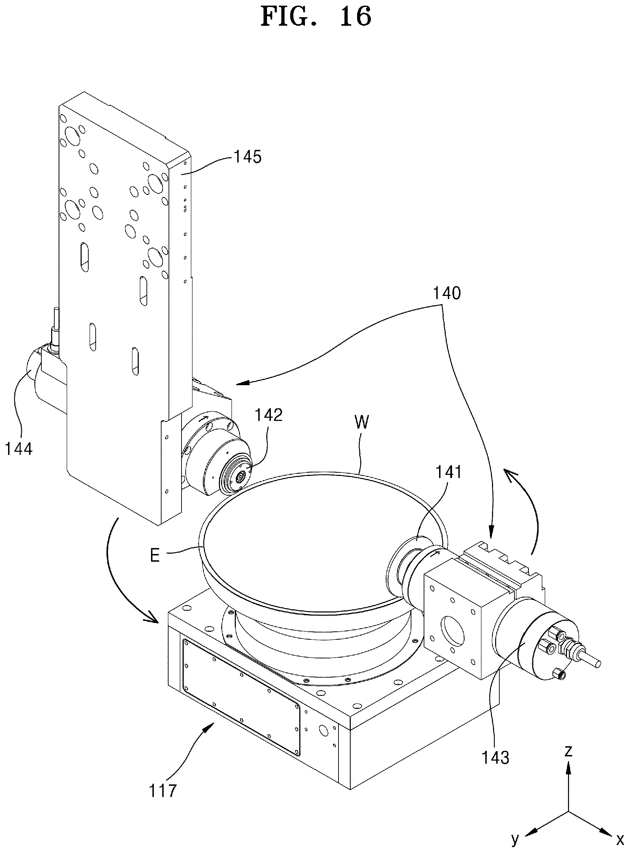

The edge processing device 140 may be disposed at one side of the wafer processing system 10 and may be movable toward the wafer seated on the support table 117. The edge processing device 140 performs a function of processing an edge portion of the wafer. The edge processing device 140 may configured as a single device or may be provided as a plurality of edge processing devices 140 to process the edge of the wafer. For example, as shown in FIG. 16, the edge processing device 140 may include two processing devices arranged to face each other to process the edge of a wafer.

The edge processing device 140 may include an edge wheel 141 (refer to FIG. 16), a second spindle 143 (refer to FIG. 16), and a second support plate 145. The edge processing method of the edge processing device 140 is described below.

The controller 150 may control each component of the wafer processing system 10 so that the wafer processing system 10 processes the wafer. The controller 150 may acquire movement information or image information from each component, and may control each component using the acquired information. The controller 150 may include a processor for performing a process.

Here, the processor may be configured to process instructions of a computer program by performing basic arithmetic, logic, and input/output operations. The instructions may be provided to the processor by a memory or receiver. For example, the processor may be configured to execute instructions received according to program codes stored in a recording device, such as a memory. Here, the 'processor' may refer to a data processing device embedded in hardware having a physically structured circuit to perform functions expressed by codes or instructions included in a program, for example.

The data processing device embedded in the hardware may include, for example, a microprocessor, a central processing unit (CPU), a processor core, a multiprocessor, an application-specific integrated circuit (ASIC), and a field programmable gate array (FPGA), but the scope of the present disclosure is not limited thereto.

The automatic tool replacing device 160 may automatically replace the notch wheel 131 according to a state of the notch wheel 131, by interworking with the notch processing device 130. In addition, the automatic tool replacing device 160 may perform a function of automatically replacing the edge wheel 141 according to the state of the edge wheel 141 of the edge processing device 140.

The inspection device 170 may identify a state of the notch wheel 131 of the notch processing device 130 or a state of the edge wheel 141 of the edge processing device 140, analyze the presence or absence of abnormality or the degree of deterioration, and determine whether the notch wheel 131 or the edge wheel 141 needs to be replaced.

The cleaning device 180 performs a function of cleaning the wafer that has been processed by the notch processing device 130 or the edge processing device 140. The cleaning device 180 may include a first cleaning unit 183 cleaning an upper surface of the wafer and a second cleaning unit 181 cleaning a lower surface of the wafer opposite to the upper surface.

Here, the upper surface of the wafer may be a surface on which semiconductor devices are formed, and may be a surface on which notch processing or edge processing is performed. The lower surface of the wafer may be a reverse surface opposite to one surface, and may be a surface on which a back grinding process is performed to reduce a thickness of the wafer.

The order of cleaning the upper and lower surfaces of the wafer by the cleaning device 180 is not limited, but in an embodiment, the upper surface on which the notch trimming process and the edge process are performed may be first cleaned, the wafer may be turned over, and the lower surface of the wafer on which the back grinding process is performed may then be cleaned. However, the present disclosure is not limited thereto, and the cleaning device 180 may include only the second cleaning unit 181 cleaning the lower surface of the wafer, and clean the lower surface of the reversed wafer after the notch trimming process and the edge process are completed. In this case, the upper surface of the wafer may be cleaned through polishing water supplied during the notch trimming process or the edge process.

Hereinafter, the cleaning device 180 of the wafer processing system 10 is described in detail with reference to the drawings.

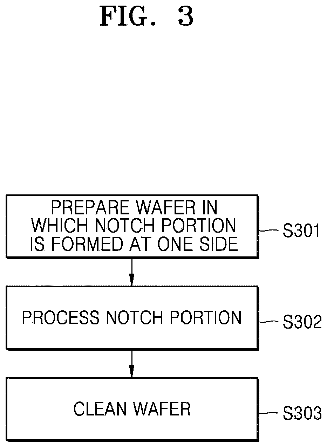

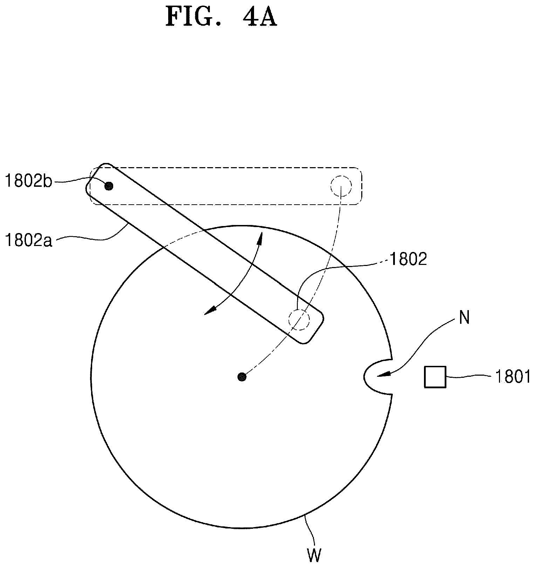

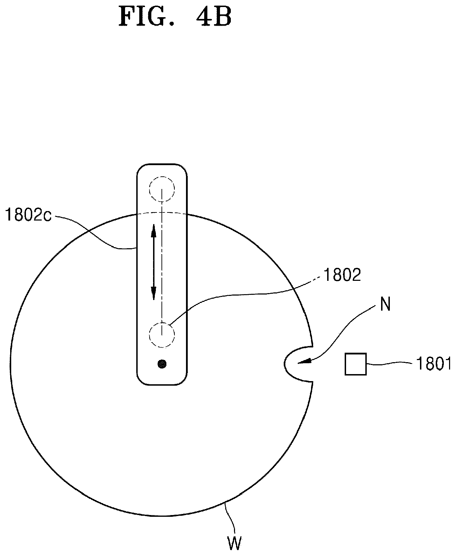

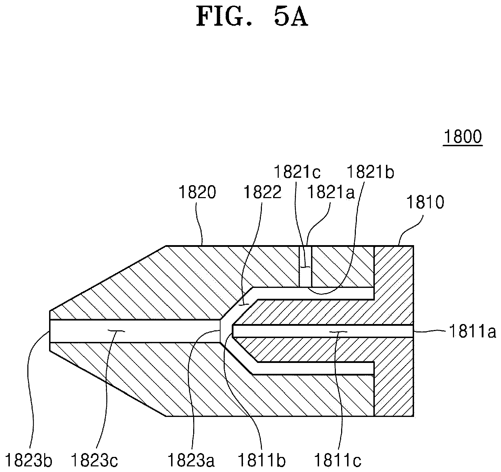

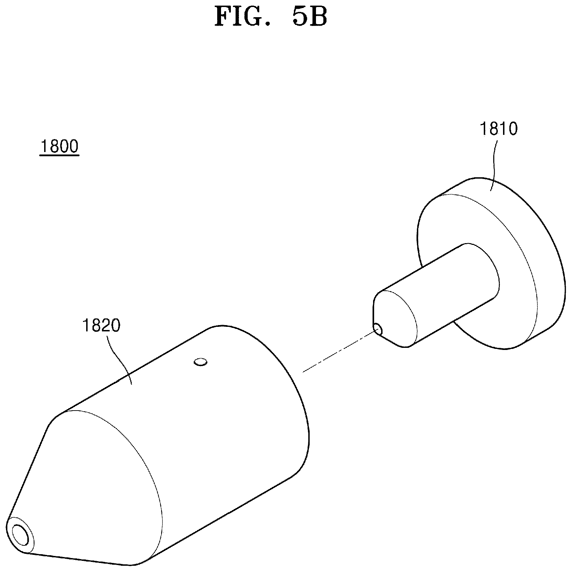

FIG. 3 is a flowchart of a wafer processing method according to an embodiment of the present disclosure. Also, FIG. 4 shows a path of a nozzle 1802 for cleaning one surface of a wafer W according to an embodiment of the present disclosure, in which FIG. 4a shows the nozzle 1802 that makes a reciprocating turning motion and FIG. 4b shows the nozzle 1802 that makes a reciprocating rectilinear motion. Also, FIG. 5 is a diagram illustrating a nozzle 1800 according to an embodiment of the present disclosure, in which FIG. 5A is a cross-sectional view of the nozzle 1800, and FIG. 5B is an exploded perspective view of the nozzle 1800.

An operation of cleaning the wafer W using the cleaning device 180 is one operation of wafer processing according to an embodiment of the present disclosure and may be configured to prepare a wafer having a notch portion formed at one side thereof, processing the notch portion so that a certain region of the notch portion has a preset thickness, and clean the wafer by supplying cleaning water.

The cleaning device may include the nozzle 1800 supplying cleaning water to the wafer W, and one or more nozzles 1800 may be provided. As cleaning water supplied through the nozzle 1800, polishing water supplied during the notch trimming process or the edge process may be used.

Among the nozzles 1800, a certain nozzle 1801 may be prepared to supply cleaning water to a notch portion N from the inside of the wafer W to the outside or from the outside of the wafer W to the inside, to clean the notch portion N.

Also, while the nozzle 1801 supplies cleaning water to the notch portion N or before or after the nozzle 1801 supplies cleaning water to the notch portion N, another nozzle 1802 may further supply cleaning toward one surface of the wafer W in order to clean one surface of the wafer W. At this time, the nozzle 1802 supplying cleaning water toward one surface of the wafer W may be configured to supply cleaning water, while reciprocating on the wafer W.

For example, as shown in FIG. 4a, when the arm 1802a is pivotally rotated in a certain region on the wafer W around an arm support shaft 1802b, the nozzle 1802 supplying cleaning water toward one surface of the wafer W may be configured such that one end thereof is fixed to the other end of the arm 1802a coupled to the arm support shaft 1802b and makes a reciprocating turning motion, while drawing an arc in a region between the center of the wafer W and an outer circumference. At this time, the arm support shaft 1802b may be connected to a motor (not shown) for rotating the arm support shaft 1802b.

Alternatively, as shown in FIG. 4b, the nozzle 1802 supplying cleaning water toward one surface of the wafer W may be installed to reciprocate in a girder 1802c located to be apart from the water W and traverse from the center of the wafer W to the outer circumference thereof and makes a reciprocating rectilinear motion in a region between the center of the wafer W and the outer circumference. In this case, the nozzle 1802 may be drivably connected to a servomotor (not shown) driven by electricity or hydraulic pressure.

In this manner, when the nozzle 1801 supplying cleaning water toward the notch portion N and the nozzle 1802 supplying cleaning water toward the one surface of the wafer W are provided together in the cleaning device, the controller of the processing system may be configured to control driving of the nozzles 1801 and 1802 so that the nozzles 1801 and 1802 may clean the wafer W without causing interference with each other.

The nozzles 1801 and 1802 may be provided in at least one of the first cleaning unit 183 cleaning the upper surface of the wafer W and the second cleaning unit 181 cleaning the lower surface of the wafer W.

Meanwhile, as the nozzle 1800, at least one of the nozzles 1801 supplying cleaning water to the notch portion N and the nozzle 1802 reciprocating on the wafer W and supplying cleaning water toward one surface of the wafer W may include a first nozzle tip 1810 and a second nozzle tip 1820, as shown in FIG. 5. The first nozzle tip 1810 and the second nozzle tip 1820 may be integrally manufactured, or the first nozzle tip 1810 and the second nozzle tip 1820, which are separately manufactured, may be coupled to form the single nozzle 1800.

FIG. 5A is a cross-sectional view of the nozzle 1800 according to an embodiment of the present disclosure. As shown, the first nozzle tip 1810 may include a gas inlet 1811a and a gas outlet 1811b, and a gas flow path 1811c communicating between the gas inlet 1811a and the gas outlet 1811b.

The second nozzle tip 1820 may include a cleaning water inlet 1821a and a cleaning water outlet 1821b, and a cleaning water flow path 1821ccommunicating between the cleaning water inlet 1821a and the cleaning water outlet 1821b.

In addition, the second nozzle tip 1820 may include a mixed fluid inlet 1823a, a mixed fluid outlet 1823b, and a mixed fluid flow path 1823c communicating between the mixed fluid inlet 1823a and the mixed fluid outlet 1823b.

The nozzle 1800 may be configured such that the gas outlet 1811b, cleaning water outlet 1821b, and the mixed fluid inlet 1823a communicate with each other. For example, the second nozzle tip 1820 may include an accommodating portion 1822 surrounding a portion of an outer circumferential surface of the first nozzle tip 1810, and the gas outlet 1811b, the cleaning water outlet 1821b, and the mixed fluid inlet 1823a may communicate with the accommodating portion 1822.

FIG. 5B is an exploded perspective view of the nozzle 1800 according to an embodiment of the present disclosure, when the first nozzle tip 1810 and the second nozzle tip 1820 are separately manufactured and coupled, the first nozzle tip 1810 and the second nozzle tip 1820 may be coupled to form the nozzle 1800. At this time, in a state in which at least a portion of the first nozzle tip 1810 is inserted into an accommodating recess formed at one side of the second nozzle tip 1820, the first nozzle tip 1810 may be coupled to the second nozzle tip 1820. Also, the accommodating portion 1822 may be provided between the first nozzle tip 1810 and the second nozzle tip 1820 as a portion of the accommodating recess.

Referring to flow of gas and cleaning water flowing into the nozzle 1800, first, cleaning water flowing into cleaning water inlet 1821a may be discharged to cleaning water outlet 1821b through cleaning water flow path 1821c and then flow into the accommodating portion 1822. Also, gas introduced into the gas inlet 1811a may be discharged to the gas outlet 1811b through the gas flow path 1811c and then introduced into the accommodating portion 1822. The gas and cleaning water introduced into the accommodating portion 1822 may be mixed in the accommodating portion 1822, introduced into the mixed fluid inlet 1823a, and then discharged to the mixed fluid outlet 1823b through the mixed fluid flow path 1823c.

The gas may flow into the gas inlet 1811a at a certain pressure so that the gas may flow linearly at a high speed, while forming a laminar flow in the gas flow path 1811c, and the gas flow path 1811c may extend to have a length longer than a diameter thereof.

Also, the gas outlet 1811b may be adjacent to the mixed fluid inlet 1823a so that the gas discharged to the gas outlet 1811b may be mixed with the cleaning water introduced into the accommodating portion 1822 and directly introduced into the mixed fluid inlet 1823a.

The gas discharged at a certain pressure through the gas outlet may flow into the mixed fluid inlet 1823a together with cleaning water accommodated in the accommodating portion 1822, and at this time, the mixed fluid may include gas bubbles generated as the gas is mixed with the cleaning water. Cleaning power of the wafer W may be improved by impact force applied by the mixed fluid to the surface of the wafer W when the mixed fluid including gas bubbles is discharged to the mixed fluid outlet 1823b and collides with the surface of the wafer W and additional impact force applied to the surface of the wafer W as the gas bubbles included in the mixed fluid burst.

The cleaned wafer may be carried out of the wafer processing system 10 by the transfer device 110 described above.

Meanwhile, the wafer processing system 10 according to an embodiment of the present disclosure may further include a back grinding device (not shown). After the processing of the notch portion N or an edge portion E is completed by the notch processing device 130 or the edge processing device 140, the wafer processing system 10 may polish one surface of the wafer W using the back grinding device (not shown).

As described above, because the thickness of the notch portion N and the edge portion E of the wafer W is reduced, the wafer processing system 10 does not damage the notch portion N during the back grinding process, thereby improving the yield of the wafer W.

Hereinafter, a wafer processing method of the wafer processing system 10 is described with each component of the wafer processing system 10 in detail with reference to the drawings.

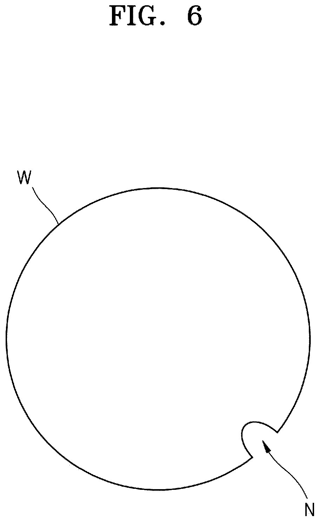

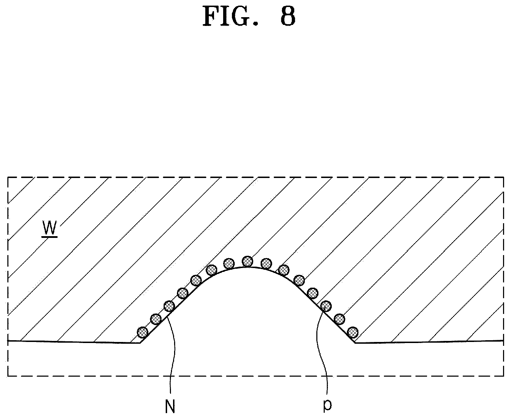

FIG. 6 is a diagram schematically illustrating a wafer W as a processing target, FIG. 7 is a diagram illustrating the alignment device 120, and FIG. 8 is a diagram illustrating a method of extracting edge information of the notch portion N.

Referring to FIGS. 6 to 8, the wafer processing system 10 prepares the wafer W having a notch portion N formed at one side thereof.

Here, the wafer W may be in a state in which devices are formed on one surface. The type, size, and shape of the wafer W are not particularly limited. For example, the wafer W may include silicon, germanium, quartz, or sapphire. The wafer W may be a substrate on which a semiconductor device is formed or a substrate on which a display, such as a liquid crystal display (LCD), organic light emitting diode (OLED), or light emitting diode (LED) is formed.

The notch portion N which is concave toward the center of the wafer W may be formed in the wafer W. In general, the wafer W is aligned using a pattern, such as a line on a wafer surface or an align key, but there is a problem in that it is difficult to recognize such a pattern or align key because a resin layer is applied to protect the wafer surface during device processing. The notch portion N is formed at one side of the wafer W to solve the problem, and the wafer processing system 10 recognizes a position of the notch portion N by a vision camera and aligns the wafer W.

When the wafer W is brought in from the outside, the wafer processing system 10 may seat the wafer W on the support table 117 on which a processing operation is performed, using the transfer device 110. The wafer W may be primarily aligned by the pre-aligner 113 of the transfer device 110 and then transferred to the support table 117.

When the wafer W is seated on the support table 117, the wafer processing system 10 may recognize a position of the wafer W using the alignment device 120 and align the wafer W before processing. The alignment device 120 may include the lighting unit 121 and the vision camera 123.

The lighting unit 121 and the vision camera 123 may be disposed to face each other with respect to the wafer W, and in an embodiment, the lighting unit 121 may be located below the wafer W to irradiate light toward the wafer W and the vision camera 123 may be located above the wafer W and captures an image of the wafer W to which the light is irradiated to acquire image information M1.

The type of the vision camera 123 is not particularly limited. For example, the vision camera 123 may be a general optical camera, a time of flight (ToF) camera, or a lidar.

The controller 150 of the wafer processing system 10 may analyze the received image information M1 and align the wafer W. The controller 150 may align the wafer W by controlling a position of the support table 117, or may control the notch processing device 130 or the edge processing device 140 using position information of the notch portion N.

In detail, the controller 150 may extract a plurality of points (e.g., 4 or more points) on the wafer W using the image information M1 acquired through the alignment device 120, and identify a deviation of the center point of the wafer W from a rotating shaft of the support table 117 or positions of the notch processing device 130, the edge processing device 140, and the wafer W in advance.

Thereafter, the controller 150 may control the notch processing device 130 and the edge processing device 140 to move according to a set movement path based on the identified position information of the components.

In addition, the controller 150 may extract edge information of the notch portion N by analyzing the image information M1 of the notch portion N. In a state in which the lower surface or the upper surface of the wafer W is irradiated with light using the lighting unit 121, the controller 150 may analyze the image information M1 of the notch portion N captured by the vision camera 123 located to face the lighting. As shown in FIG. 8, in the image information M1, a region of the wafer W may block light to be dark, and the notch portion N may allow light to pass therethrough to be bright. The controller 150 may extract edge information of the notch portion N using a contrast difference.

In detail, the edge information of the notch portion N may include information on a plurality of edge points p extracted along an edge line of the notch portion N. In an embodiment, as shown in FIG. 8, the controller 150 may extract the plurality of edge points p at regular intervals along the edge line of the notch portion N.

The controller 150 may set a processing path of the notch wheel 131 using the extracted edge information and previously planned notch processing information. The processing path of the notch wheel 131 may be set based on the center O1 of the notch wheel 131, and may be set along an edge line outside the wafer W as shown in FIG. 9 described below.

Here, when the controller 150 controls the notch processing device 130 to move according to the set movement path, the set movement path may be a path along which the notch processing device 130 moved during previous processing of the wafer W. In the case of wafers provided to the wafer processing system 10 in one manufacturing unit (LOT unit), the notch portion N of the wafer W may be formed in a similar shape.

In processing the notch portion of a currently processed wafer, the wafer processing system 10 according to an embodiment of the present disclosure controls the notch processing device 130 to move along the set movement path used to process a notch portion of a previously processed wafer, thereby maximizing notch processing efficiency.

In this case, however, the movement path set when processing the previous wafer is not simply applied immediately, and the controller 150 of the wafer processing system 10 may identify whether an edge line of the notch portion N of the wafer W is different from an edge line of the notch portion of the previous wafer using the received image information M1, and may change the set movement path of the current wafer W when there is a difference therebetween.

In other words, the wafer processing system 10 may analyze the image information of the notch portion of the wafer, and if there is no difference between the previous wafer and the current wafer, the wafer processing system 10 processes the notch portion along the processing path of the previous wafer, and if there is a difference, the wafer processing system 10 may reset the movement path of the notch processing device, thereby accurately and efficiently performing the notch processing process.

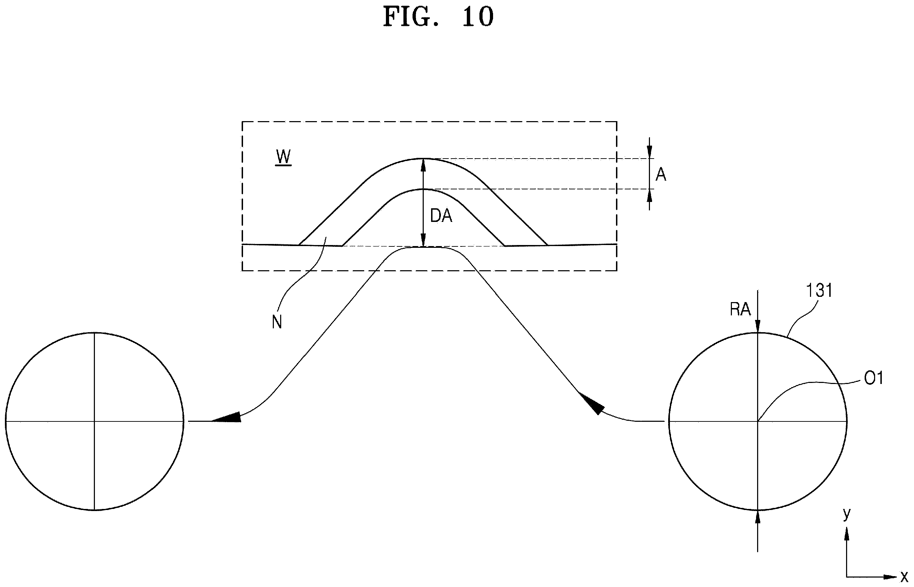

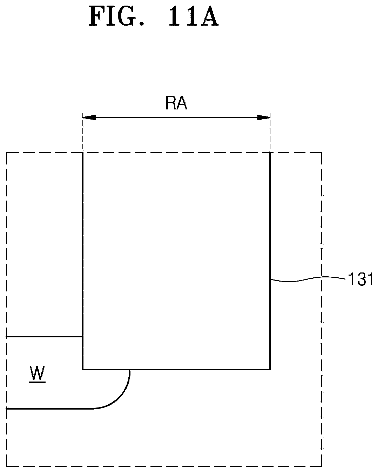

FIG. 9 is a diagram schematically illustrating the notch processing device 130 according to an embodiment of the present disclosure, FIG. 10 is a conceptual diagram illustrating a wafer processing method using the notch processing device 130 of FIG. 9, and FIGS. 11A to 11C are diagrams illustrating a portion processed by the wafer processing method.

Referring to FIGS. 9 to 11C, when the wafer W is aligned on the support table 117, the wafer processing system 10 may perform a trimming process of reducing a thickness of the notch portion N of the wafer W or a cutting process of cutting a portion of the notch portion N using the notch processing device 130.

As shown in FIG. 11A, the notch processing device 130 may include the notch wheel 131 having a preset diameter RA and the first spindle 133 connected to the notch wheel 131.

The notch wheel 131 may be a member that directly processes the wafer W, and may be connected to one end of the first spindle 133. The notch wheel 131 may process the wafer W, while rotating by the rotation of the first spindle 133. For example, the notch wheel 131 may process the notch portion N formed in the wafer W to reduce the thickness of the notch portion N or cut a portion of the notch portion N.

The first spindle 133 may rotate around a rotation axis Ax1, and to this end, the first spindler 133 may include a motor (not shown). In an embodiment, the first spindle 133 may be disposed on the first support plate 135. The first support plate 135, in a state of being connected to a gantry (not shown) or the like, may move toward the support table 117 on which the wafer W is seated.

In addition, the first spindle 133 may rotate and move, while connected to the first support plate 135. Alternatively, when the notch processing device 130 is fixed by the first support plate 135, the support table 117 may move and rotate to the notch processing device 130 to perform notch processing. Hereinafter, for convenience of description, a case in which the notch processing device 130 moves to the support table 117 to perform notch processing is described.

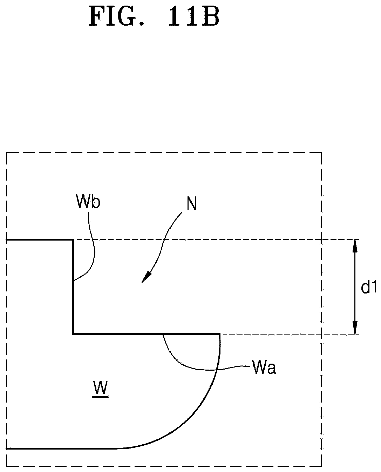

After the wafer W is aligned, the wafer processing system 10 may process the notch portion N using the notch wheel 131 so that a certain region of the notch portion N has a preset thickness (d1, refer to FIG. 11B). At this time, a diameter RA of the notch wheel 131 may be greater than a width A of a certain region of the notch portion N to be processed.

In other words, the wafer processing system 10 may process the notch portion N, while controlling the notch wheel 131 so that the center O1 of the notch wheel 131 does not overlap the notch portion N. That is, while the notch processing is performed, the center O1 of the notch wheel 131 may be located outside the wafer W.

In an embodiment, the diameter RA of the notch wheel 131 may be larger than twice the width A of a certain region of the notch portion N to be processed. Referring to FIG. 10, a radius RA/2 of the notch wheel 131 may be equal to a unique width DA of the notch portion N. In this case, the unique width DA of the notch portion N may be a distance (distance on an x-y plane) from the edge line of the wafer W to a certain region in which the notch processing is performed.

In detail, as shown in FIG. 11A, the wafer processing system 10 may process the wafer W in a state in which a portion of the notch wheel 131 having the first diameter RA is in contact with the wafer W. At this time, the notch wheel 131 may have a cylindrical shape, and the upper surface Wa and the side surface Wb of the wafer W processed by the notch wheel 131 may be perpendicular to each other as shown in FIG. 11B.

However, the upper surface Wa and the side surface Wb may correspond to the shape of the notch wheel 131. For example, when an angle of the edge portion of the notch wheel 131 has a value in the range of 86° to 94°, an angle between the upper surface Wa and the side surface Wb may be determined as a value in the range of 94° to 86°.

In an embodiment, when processing the wafer W using the notch processing device 130, the wafer processing system 10 may process the notch portion N by controlling the notch processing device 130 to move in a vertical direction (a z direction in FIG. 9) perpendicular to one surface of the wafer. At this time, in a state in which the coordinates of the notch wheel 131 on the plane (the x-y plane) are fixed, the notch wheel 131 may move in the vertical direction (the z direction) toward the notch portion N of the wafer W to process the notch portion N.

In another embodiment, when processing the wafer W using the notch processing device 130, the wafer processing system 10 may process the notch portion N by controlling the notch processing device 130 to move in a horizontal direction (an x-y direction) horizontal to one surface of the wafer. At this time, in a state in which the coordinates of the notch wheel 131 are fixed in the vertical direction (the z direction), the notch wheel 131 may move in the horizontal direction (the x-y direction) toward the notch portion N of the wafer W to process the notch portion N.

In another embodiment, the wafer processing system 10 may perform depth processing in the vertical direction (the z direction) perpendicular to one surface of the wafer first using the notch processing device 130, and then perform width or breadth processing in the horizontal direction (the x-y direction).

In another embodiment, using the notch processing device 130, the wafer processing system 10 may process the notch portion N of the wafer W by controlling the notch processing device 130 to simultaneously move in the horizontal direction (the x-y direction) and the vertical direction (the z direction).

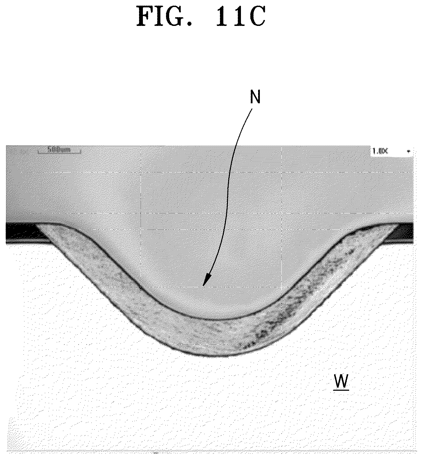

When the processing of the notch portion N of the wafer W using the notch processing device 130 is completed, the thickness of a certain region of the notch portion N may be changed and shade may occur as shown in FIG. 11C.

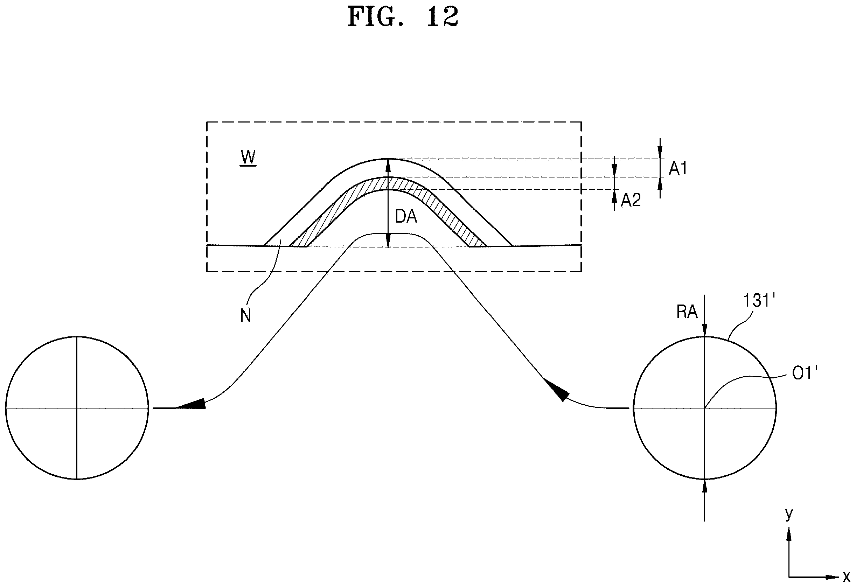

FIG. 12 is a conceptual diagram illustrating a wafer processing method using a notch processing device according to another embodiment, and FIGS. 10a to 10c are diagrams illustrating portions processed by the wafer processing method of FIG. 9.

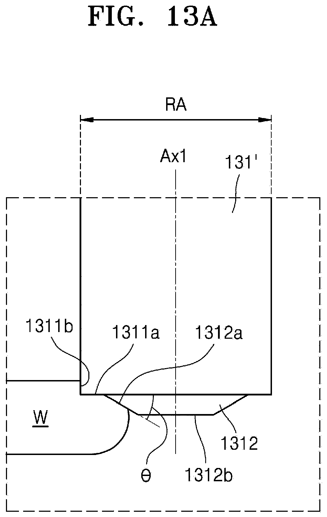

Referring to FIGS. 12 to 13C, a notch wheel 131' of the notch processing device 130 according to another embodiment of the present disclosure may include a first processing portion 1311 and a second processing portion 1312. Through this, a certain region of the notch portion N processed by the notch wheel 131' according to another embodiment may include a first region n1 having a first thickness d1 and a second region n2 having a second thickness d2, different from the first thickness d1.

A certain region of the notch portion N processed by the notch wheel 131' according to another embodiment may include the first region n1 having a first width A1 and the second region n2 having a second width A2 in a plan view.

In FIG. 12, a case in which a diameter RA' of the notch wheel 131' is smaller than the diameter RA of the notch wheel 131 of FIG. 10 is shown as an example, and even in this case, the diameter RA of the notch wheel 131' may be greater than a width (A1+A2) of the certain region of the notch portion N. Therefore, while the notch portion N is being processed, the center O1' of the notch wheel 131' may not overlap the wafer W and may be located outside the wafer W.

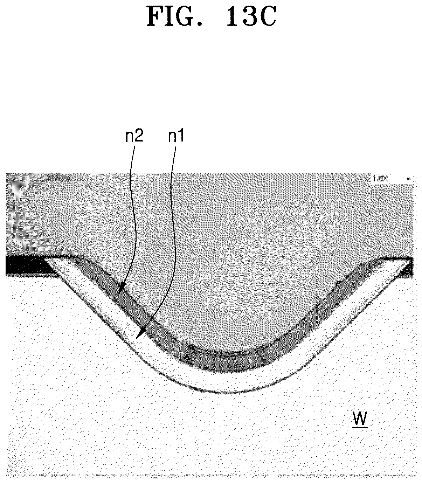

In the case of processing the notch portion N using the notch wheel 131 of FIG. 11A, the notch portion N is expressed with only one shade as shown in FIG. 11C. In contrast, in the case of processing using the notch wheel 131' including the first processing portion 1311 and the second processing portion 1312, the notch portion N may be expressed with two shades due to a difference in thickness as shown in FIG. 13C, and thus, the notch portion N may be more clearly recognized by a vision camera.

In an embodiment, the second region n2 of the notch portion N may include an inclined surface We. In other words, the second region n2 of the notch portion N may not be uniformly formed to have the second thickness d2, but have a shape gradually changing from the first thickness d1 of the first region n1 to the second thickness d2.

In detail, as shown in FIG. 13A, the first processing portion 1311 may have the same shape as that of the notch wheel 131 of FIG. 11A and may have a cylindrical shape coaxially located with the rotation axis Ax1 of the first spindle 133.

The first processing portion 1311 may be a portion located outside the notch wheel 131 and may include a first processing surface 1311a and a second processing surface 1311b. The first processing surface 1311a and the second processing surface 1311b may be formed substantially vertically like the notch wheel of FIG. 11A.

The first processing surface 1311a may contact the upper surface Wa of the notch portion N and process the upper surface Wa according to rotation of the first spindle 133. In an embodiment, the first processing surface 1311a may be a bottom surface of the first processing portion 1311 and may be located to be parallel to the upper surface Wa of the notch portion N.

The second processing surface 1311b may contact the side surface Wb of the notch portion N and process the side surface Wb according to rotation of the first spindle 133. In an embodiment, the second processing surface 1311b may be a side surface of the first processing portion 1311 and may be located to be parallel to the side surface Wb of the notch portion N.

The second processing portion 1312 may be disposed at one side of the first processing portion 1311. In an embodiment, the second processing portion 1312 is located inside the first processing portion 1311 in a radial direction and may be located coaxially with the rotation axis Ax1 of the first spindle 133.

As shown in the drawing, the second processing portion 1312 may have a tapered surface 1312a and a flat surface 1312b. The tapered surface 1312a may be located to process the inclined surface We of the notch portion N.

In an embodiment, the second processing portion 1312 may have a circular truncated cone shape, and the tapered surface 1312a may correspond to a side surface of the second processing portion 1312. In addition, the tapered surface 1312a may be located to form a first angle θ with the first processing surface 1311a of the first processing portion 1311.

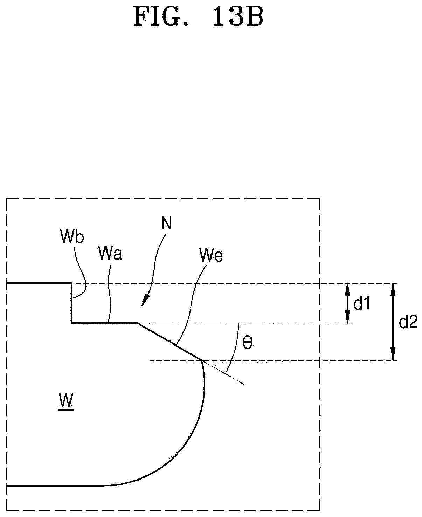

Accordingly, an upper surface Wa, a side surface Wb, and an inclined surface We may be formed in the notch portion N of the wafer W processed by the notch processing device 130. In detail, as shown in FIGS. 13A and 13B, the upper surface Wa and the side surface Wb of the notch portion N may be processed by the first processing portion 1311, and the inclined surface We of the notch portion N may be processed by the second processing portion 1312.

In addition, the upper surface Wa and the inclined surface We of the notch portion N may be located to form the first angle θ which is the same as the first angle θ formed between the first processing surface 1311a and the tapered surface 1312a. Therefore, shade may be formed on the inclined surface We, which is inclined downwardly relative to the upper surface Wa, and a boundary line may be formed between the upper surface Wa and the inclined surface We.

In another embodiment, the alignment device 120 may capture an image of a device surface of the wafer W, and identify a defective device having a protrusion or the like based on the captured image. Thereafter, the wafer processing system 10 may perform a process of removing a defective device of the wafer W using the notch processing device 130.

The alignment device 120 inspects the device surface of the wafer W after processing of the notch portion N and/or processing of the edge portion E is completed or before processing is performed. At this time, the device surface of the wafer W may have a protrusion due to foreign matter or the like during a manufacturing process. Such a protrusion may deteriorate quality of the wafer W and may collide with a device during another process to cause damage or the like.

When the alignment device 120 captures an image of the device surface of the wafer W, the notch processing device 130 may be used to process the notch portion N of the wafer W, as well as to remove a defective device of the wafer W. For example, the notch processing device 130 scrape and remove a defective device using the notch wheel 131.

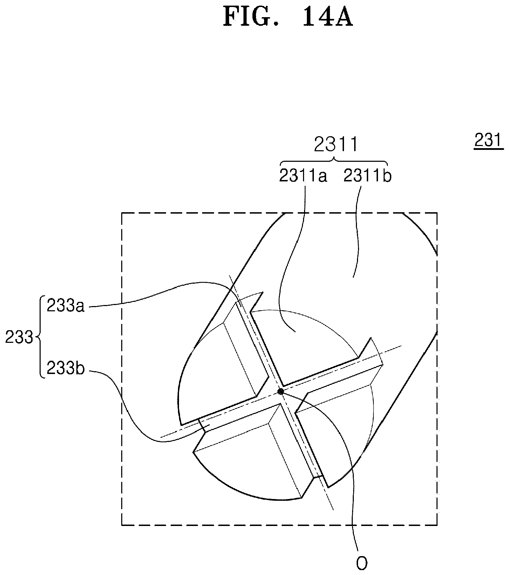

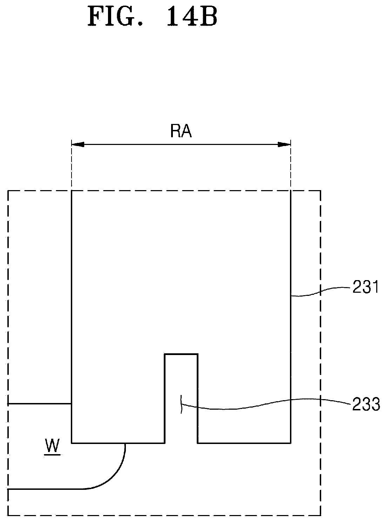

FIGS. 14A and 14B are diagrams illustrating a notch wheel 231 according to another embodiment.

Referring to FIGS. 14A and 14B, the notch wheel 231 according to another embodiment includes a processing portion 2311 including a first processing surface 2311a in contact with the wafer W. At this time, the processing portion 2311 may refer to an end portion of the notch wheel 231. Compared to the notch wheel 131 of FIG. 11A, the notch wheel according to another embodiment may include a slit portion 233 formed to divide the processing portion 2311 into two or more parts.

The slit portion 233 may divide the processing portion 2311, which is an end portion of the notch wheel 231, into two or more parts. For example, as shown in FIG. 14A, the slit portion 233 may include a first slit 233a dividing the processing portion 2311 in a first direction and a second slit 233a dividing the processing portion 2311 in a second direction, different from the first direction.

In detail, the first slit 233a may be formed as a groove concave toward the inside of the notch wheel 231 from the first processing surface 2311a of the processing portion 2311. The first slit 233a may be formed in the first direction and may be formed in a shape passing through the second processing surface 2311b, which is a side surface of the processing portion 2311.

Similarly, the second slit 233b may be formed as a groove concave toward the inside of the notch wheel 231 from the first processing surface 2311a of the processing portion 2311. The second slit 233b may be formed in the second direction, crossing the first direction, and may be formed in a shape passing through the second processing surface 2311b, which is the side surface of the processing portion 2311.

The first slit 233a and the second slit 233b may cross at the center O of the notch wheel 231, and as shown, the first slit 233a and the second slit 233b may be located in a cross shape. The first slit 233a may divide the processing portion 2311 in the first direction, and the second slit 233b may divide the processing portion 2311 in the second direction. However, this is only an embodiment, and the present disclosure is not limited to the shape and number of the slit portion 233.

The slit portion 233 may perform a function of smoothly supplying a polishing water supplied during the notch processing process to the entire notch wheel 231. In other words, because the slit portion 233 is formed on the first processing surface 2311a of the processing portion 2311, processing may be performed, while supplying polishing water directly to the upper surface of the notch portion N. In addition, because the polishing water continuously circulates through the slit portion 233, chips occurring in the process of polishing the wafer W may be easily discharged.

In an embodiment, the first slit 233a and the second slit 233b may be grooves having a depth in a vertical direction with respect the first processing surface 2311a. Through this, the divided processing portion 2311 may have angled corners, and these corners may serve as processing blades in the process of processing the wafer W. A grinding force of the notch wheel 231 having the slit portion 233 may be improved, so that processing quality of the wafer W may be further improved.

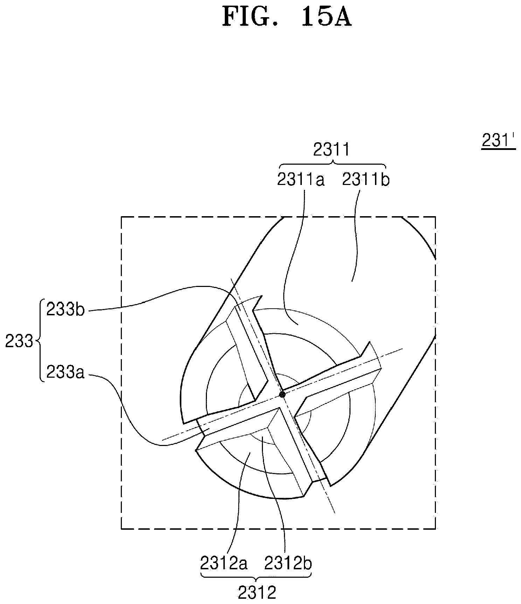

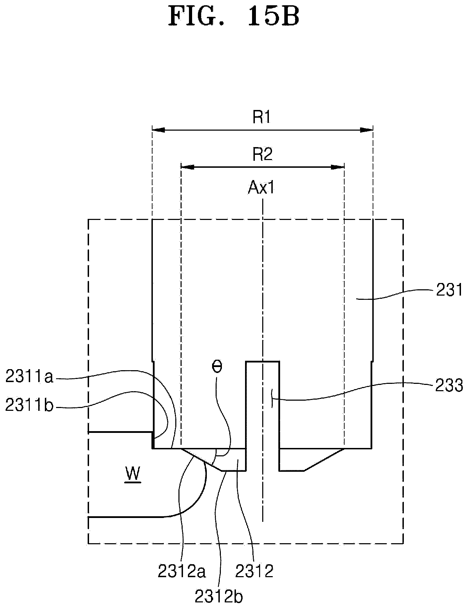

FIGS. 15A and 15B are diagrams illustrating a notch wheel 231' according to another embodiment.

Referring to FIGS. 15A and 15B, like the notch wheel 131' of FIG. 13A, the notch wheel 231' according to another embodiment may include a first processing portion 2311 and a second processing portion 2312 and may include a slit portion 233 formed to divide the first processing portion 2311 and the second processing portion 2312 into two or more parts.

The first processing portion 2311 may have a first diameter R1, and the second processing portion 2312 may have a second diameter R2 smaller than the first diameter R1 and may be located at one end of the first processing portion 2311 to protrude outwardly from the one end of the first processing portion 2311.

The first processing portion 2311 may be a portion located at an outer portion of the notch wheel 231 and may include a first processing surface 2311a and a second processing surface 2311b. The first processing surface 2311a and the second processing surface 2311b may be formed to be substantially perpendicular to each other, like the notch wheel of FIG. 11A.

The second processing portion 2312 may be disposed at one side of the first processing portion 2311. In an embodiment, the second processing portion 2312 may be located radially inside the first processing portion 2311 and may be disposed coaxially with the rotation axis Ax1 of the first spindle 133.

As shown in the drawing, the second processing portion 2312 may have a tapered surface 2312a and a flat surface 2312b. The tapered surface 2312a may be disposed to process the inclined surface We of the notch portion N.

In an embodiment, the second processing portion 2312 may have a circular truncated cone shape, and the tapered surface 2312a may correspond to a side surface of the second processing portion 2312. In addition, the tapered surface 2312a may be disposed to form a first angle θ with the first processing surface 2311a of the first processing portion 2311.

The slit portion 233 may divide the first processing portion 2311 and the second processing portion 2312, which are end portions of the notch wheel 231, into two or more parts. For example, as shown in FIG. 15A, the slit portion 233 may include a first slit 233a dividing the first processing portion 2311 and the second processing portion 2312 in the first direction and a second slit 233b dividing the first processing portion 2311 in the second direction, different from the first direction.

In detail, the first slit 233a may be formed as a concave groove toward the inside of the notch wheel 231 from the first processing surface 2311a of the processing portion 2311. The first slit 233a may be formed in the first direction to pass through the second processing surface 2311b which is a side surface of the processing portion 2311.

In another embodiment, the first slit 233a and the second slit 233b may be disposed to have different depths. Through this, a step may be formed between the first slit 233a and the second slit 233b.

In another embodiment, the first slit 233a and the second slit 233b may be located to have an inclination. For example, the first slit 233a and the second slit 233b may be formed to have the same first angle θ as that of a slope of the tapered surface 2312a toward the center O of the notch wheel 231.

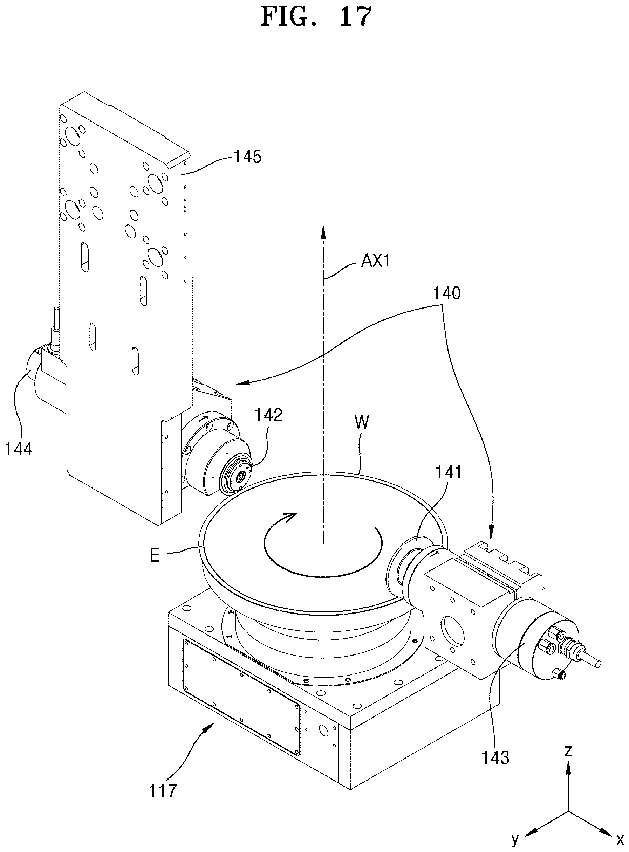

FIGS. 16 and 17 are diagrams illustrating the edge processing device 140 according to an embodiment of the present disclosure.

Referring to FIGS. 16 and 17, the edge processing device 140 is located at one side of the wafer processing system 10 and may perform a function of processing an edge portion of the wafer W. When the wafer W is seated on the support table 117, the edge processing device 140 may move toward the support table 117 and process the edge portion E of the wafer W.

The wafer processing system 10 according to an embodiment of the present disclosure may perform a back grinding process immediately after processing the notch portion N of the wafer W, but, if necessary, the wafer processing system 10 may perform a trimming process of reducing a thickness of the edge portion E of the wafer W using the edge processing device 140.

The edge processing device 140 may include an edge wheel and a second spindle. At this time, the edge wheel may be processed along the edge portion E of the wafer W, and here, the edge portion E may be processed so that a certain area of the edge portion E has a preset thickness. The edge wheel may be mounted at one end of the second spindle, and the edge wheel may be mounted to be rotatable about a rotation axis.

In an embodiment, the edge processing device 140 may include two edge wheels and two spindles. In detail, the edge processing device 140 may include a first edge wheel 141 and a (2-1)-th spindle 143 connected to the first edge wheel 141. In addition, although not shown, the edge processing device 140 may include a (2-1)-th support plate (not shown) connected to the (2-1)-th spindle 143.

In addition, the edge processing device 140 may include a second edge wheel 142 located to be opposite to the first edge wheel 141 with respect to the support table 117, a (2-2)-th spindle 144 connected to the second edge wheel 142, and a (2-2)-th support plate 145 connected to the (2-2)-th spindle 144.

The first edge wheel 141 and the second edge wheel 142, in a state of being connected to the (2-1)-th support plate (not shown) and the (2-2)-th support plate 145, respectively, may process the edge portion E of the wafer W, while rotating according to rotation of the (2-1)-th spindle 143 and the (2-2)-th spindle 144.

For example, a pair of edge processing devices 140 may process the edge portion E of the wafer W, while rotating about the support table 117 in a clockwise direction or in a counterclockwise direction.

In another embodiment, as shown in FIG. 17, the edge processing device 140, fixed in position while processing the edge portion E of the wafer W, may process the edge portion E of the wafer W, while the support table 117 rotates about the center axis Ax1 in the clockwise direction or in the counterclockwise direction.

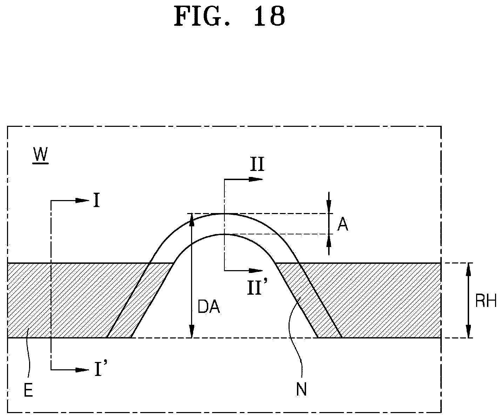

FIGS. 18 to 20B are diagrams illustrating an edge processing method according to an embodiment of the present disclosure.

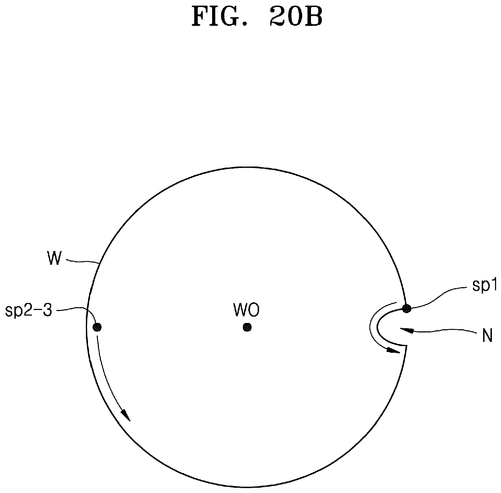

Referring to FIGS. 18 and 20B, the wafer processing system 10 may process the notch portion N of the wafer W so that a certain region of the notch portion N may have a preset first thickness, and may process the edge portion E so that a certain region of the edge portion E may have a preset second thickness.

In this case, a certain region RH of the edge portion E processed by the edge process may be smaller than the notch portion N. In detail, the certain region RH of the edge portion E may be smaller than the unique width DA of the notch portion N, which is the maximum distance from the edge line of the wafer W to the certain region A in which the notch portion N is processed. In other words, a processing width in which the first edge wheel 141 and the second edge wheel 142 contact the wafer W may be smaller than a diameter of the notch wheel 131.

At this time, a processing depth d4 of the notch portion N, which is processed to have a preset first thickness by the notch processing device 130, may be equal to or greater than a processing depth d3 of the edge portion E, which is processed to have a preset second thickness by the edge processing device 140. The processing depths d3 and d4 may be depths vertically processed from the upper surface Wt of the wafer W by the notch wheel 131 or the edge wheel 141.

By setting the processing depth d3 of the edge portion E to be equal to or smaller than the processing depth d4 of the notch portion N, the occurrence of cracks in the notch portion N due to edge processing may be minimized. For example, in the wafer processing system 10, when the notch portion N is processed to be reduced in thickness by about 180 µm, the edge portion E may be processed to be reduced in thickness by about 150 µm. However, this is only an embodiment, and both the notch portion N and the edge portion E may be processed to be reduced in thickness by about 150 µm, and may also be processed to have a different processing thickness, of course.

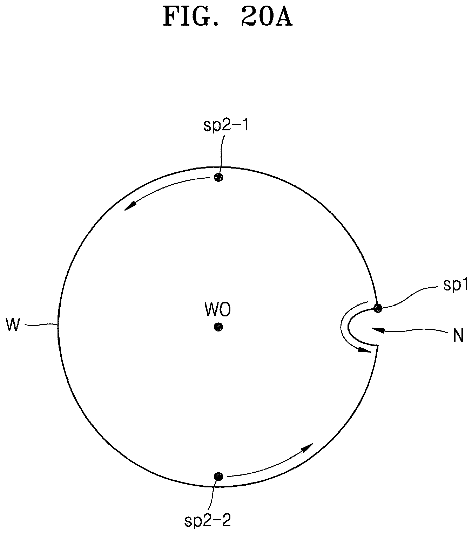

Referring to FIGS. 20A and 20B, in an embodiment, a second processing point sp2 at which the edge processing device 140 starts edge processing may be different from a first processing point sp1 at which the notch processing device 130 starts notch processing. Here, the first processing point sp1 and the second processing point sp2 may be processing positions on the wafer W.

If the edge processing device 140 includes two edge wheels 141 and 142 as shown in FIG. 16, a first processing point sp2-1 and a second processing point sp2-2 of the first edge wheel 141 may be located at the edge portion E in a direction perpendicular to the notch portion N based on the center WO of the wafer W. Alternatively, when the edge processing device 140 includes one edge wheel 141 as shown in FIG. 17, a second processing point sp2-3 of the edge wheel 141 may be located at the edge portion E opposite to the notch portion N based on the center WO of the wafer W. However, the present disclosure is not necessarily limited thereto, and the first processing point at which the notch processing starts and the second processing point at which the edge processing starts may coincide.

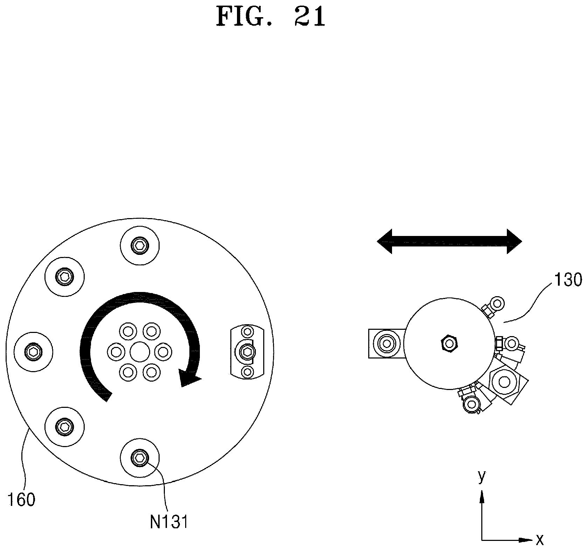

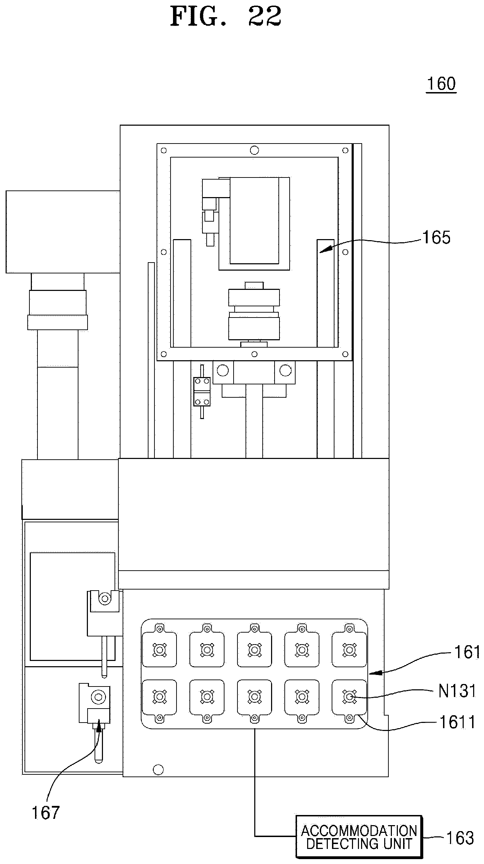

FIG. 21 is a diagram illustrating the automatic tool replacing device 160 according to an embodiment of the present disclosure, and FIG. 22 is a diagram illustrating another embodiment of the automatic tool replacing device 160.

Referring to FIG. 21, the automatic tool replacing device 160 may be located at one side of the wafer processing system 10, and may be located to be adjacent to the notch processing device 130 when the notch processing device 130 does not perform a processing process.

The automatic tool replacing device 160 performs a function of automatically replacing the notch wheel 131 of the notch processing device 130 when the notch wheel 131 is abnormal or deteriorates. In an embodiment, the automatic tool replacing device 160 may be controlled by the controller 150, and when the number of processing of the notch wheel 131 of the notch processing device 130 exceeds a preset reference, the notch wheel 131 may be replaced.

In another embodiment, the automatic tool replacing device 160 may be connected to the inspection device 170 (refer to FIG. 2) that identifies a state of the notch wheel 131, so that the inspection device 170 may identify te state of the notch wheel 131 before or after processing, and automatically replace the notch wheel 131 according to the state of the notch wheel 131.

Alternatively, the automatic tool replacing device 160 may be set to replace the notch wheel 131 when the preset number of processing is exceeded, but may periodically inspect the state of the notch wheel 131 through the inspection device 170 and immediately replace the notch wheel 131 if there is a problem even before the preset number of processing.

In detail, referring to FIG. 22, the automatic tool replacing device 160 according to an embodiment of the present disclosure may include a cassette unit 161, an accommodation detecting portion 163, a driving unit 165, and a check sensor unit 167.

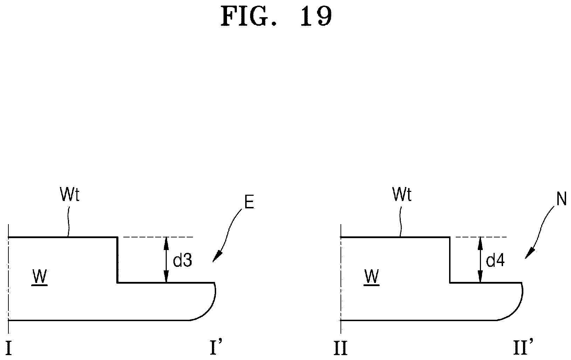

The cassette unit 161 may store a plurality of new notch wheels N131 and may include a plurality of accommodating portions 1611 for accommodating the plurality of new notch wheels N131, respectively. The cassette unit 161 may include two or more rows of the plurality of accommodating portions 1611 arranged in a line as shown in FIG. 19, and a plurality of accommodating portions 1611 arranged in a line along a rotating disk as shown in FIG. 18.

The cassette unit 161 may be fixedly installed at one side of the automatic tool replacing device 160 so that the accommodating portion 1611 is newly filled with the new notch wheel N131. However, the present disclosure is not limited thereto, and the cassette unit 161 itself may be formed in the form of a cartridge to be replaceable with respect to the automatic tool replacing device 160.

The accommodation detecting portion 163 may detect whether the new notch wheel N131 is accommodated in each of the plurality of accommodating portions 1611 of the cassette unit 161. The automatic tool replacing device 160 may recognize a position or the number of the accommodating portion 1611 without the new notch wheel N131, among the plurality of accommodating portions 1611, by using the accommodation detecting portion 163.

The driving unit 165 may be connected to the cassette unit 161 to perform a function of changing the position of the cassette unit 161 or moving the position of the plurality of accommodating portions 1611. The driving unit 165 may include components for linearly or rotationally moving the position of the cassette unit 161 or the plurality of accommodating portions 1611 according to the structure of the cassette unit 161.

In an embodiment, as shown in FIG. 21, when the cassette unit 161 is formed in a disk shape, the driving unit 165 may include components that rotate the cassette unit 161. For example, the automatic tool replacing device 160 may rotate the cassette unit 161 using the driving unit 165 to correspond to an entry position of the notch processing device 130. In other words, the automatic tool replacing device 160 may rotate the wheel cassette in which the new notch wheels N131 are accommodated using the driving unit 165, so that the new notch wheel N131 to be replaced may be positioned on the same line as one direction (the x direction) of the notch processing device 130.

The check sensor unit 167 may measure position information of the new notch wheel N131 mounted at one end of the spindle 133. In detail, the check sensor unit 167 may perform a function of acquiring length information from one end of the spindle 133 to the end of the new notch wheel N131. Through this, the automatic tool replacing device 160 may correct a positional error that may occur in the process of mounting the new notch wheel N131 and immediately perform a notch process according to a preset processing plan.

In an embodiment, the check sensor unit 167 may include a touch sensor. After mounting the new notch wheel N131 in the cassette unit 161, the notch processing device 130 may move up and down on the check sensor unit 167 located at one side of the automatic tool replacing device 160, and detect touching of an end of the new notch wheel N131, thereby acquiring location information of the new notch wheel N131.

In another embodiment, the check sensor unit 167 may be a distance measuring sensor using a laser or may acquire position information using a vision camera.

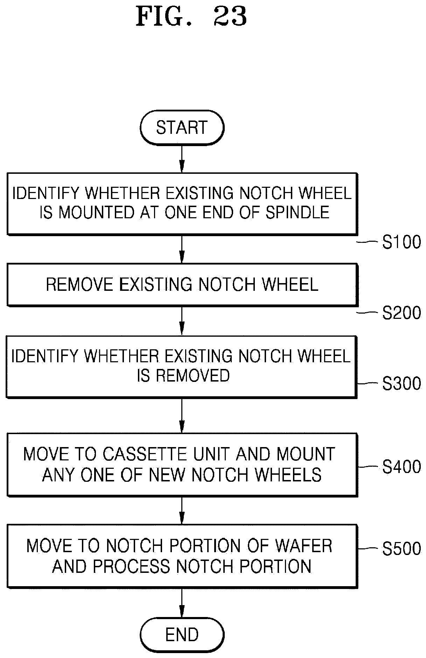

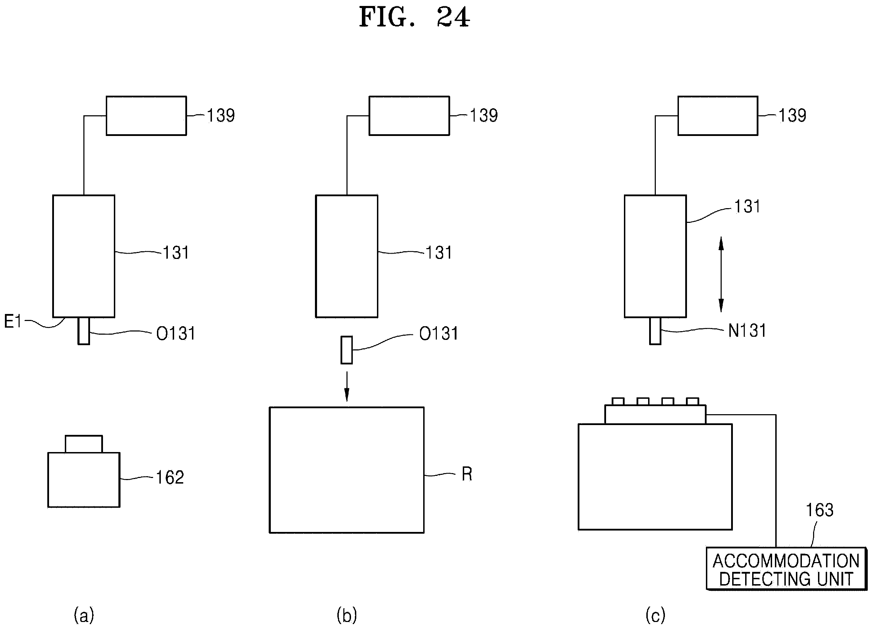

FIGS. 23 and 24 are diagrams illustrating an automatic tool replacing method according to an embodiment of the present disclosure.

Referring to FIGS. 23 and 24A, in the automatic tool replacing method, first, it is identified whether an existing notch wheel 0131 is mounted at one end of the spindle 133 (S100). At this time, the automatic tool replacing device 160 may further include a mounting sensor 162 capable of detecting whether the existing notch wheel 0131 is mounted at one end of the spindle 133. At this time, the mounting sensor 162 may include a vision camera, and whether the existing notch wheel 0131 is mounted may be identified by imaging one end of the spindle 133.

In another embodiment, the notch processing device 130 may include a notch wheel detecting unit 139 identifying whether the notch wheel 131 is mounted at one end of the spindle 133. For example, the mounting detecting unit 139 may include a contact sensor or a pressure sensor, and may identify whether the existing notch wheel 0131 is mounted at one end of the spindle 133. In another embodiment, the notch wheel detecting unit 139 of the notch processing device 130 may include an RFID reader. In other words, an RFID tag to which unique information is input may be attached to the notch wheel 131, and the notch wheel detecting unit 139 may detect whether the notch wheel 131 is mounted or whether the mounted notch wheel 131 is a new notch wheel or an existing notch wheel by acquiring tag information using the RFID reader.

Thereafter, referring to FIG. 23 and (b) of FIG. 24, in the automatic tool replacing method, when the existing notch wheel 0131 is mounted at one end of the spindle 133, the spindle 133 may be moved to a preset zone and the existing notch wheel 0131 may be removed (S200). A notch wheel collection box R for accommodating the removed existing notch wheel 0131 may be located in the pre-set zone.

Thereafter, in the automatic tool replacing method, whether the existing notch wheel 0131 is removed from one end of the spindle 133 may be identified (S300). In operation S300, whether the existing notch wheel 0131 is removed may be identified by using the mounting sensor 162 for identifying whether the existing notch wheel 0131 is mounted or by using the notch wheel detecting unit 129 included in the notch processing device 130.

Thereafter, referring to FIG. 23 and (c) of FIG. 24, in the automatic tool replacing method, the spindle 133 may be moved to the cassette unit 161 storing the plurality of new notch wheels N131, and any one of the plurality of new notch wheels may be mounted at one end of the spindle 133 (S400).

As described above, the cassette unit 161 may include the plurality of accommodating portions 1611 accommodating the plurality of new notch wheels N131, respectively. Here, in the mounting of any one of the plurality of new notch wheels N131 at one end of the spindle 133, the any one of the plurality of new notch wheels N131 may be mounted by moving the spindle 133 to any one predefined accommodating portion 1611, among the plurality of accommodation portions 1611 of the cassette unit 161.

The cassette unit 161 may include the accommodation detecting portion 163 detecting whether the new notch wheel N131 is accommodated in each of the plurality of accommodating portions 1611, and in the automatic tool replacing method, one accommodating portion 1611 to which the spindle 133 is to move may be determined using a result detected by the accommodation detecting portion 163.

In other words, the cassette unit 161 may recognize positions of the accommodating portions 1611 accommodating the new notch wheels N131 by the accommodation detecting portion 163, and extract an optimal accommodating portion 1611 to which the spindle 133 may move in the shortest manner, among the accommodating portions 1611 in which the new notch wheels N131 are accommodated. In the automatic tool replacing method, the new notch wheel N131 may be mounted by moving the spindle 133 to the extracted optimal accommodating portion 1611.

In another embodiment, in the automatic tool replacing method, when the cassette unit 161 is formed in a wheel shape as shown in FIG. 21, the cassette unit 161 may be rotated by using the driving unit 165 so that the extracted optimal accommodating portion 1611 is adjacent to a movement direction (the x direction) of the notch processing device 130. Thereafter, the notch processing device 130 may move to an upper portion of the new notch wheel N131 to be replaced.

Thereafter, the automatic tool replacing method may identify whether the replaced notch wheel N131 is properly mounted by using the check sensor unit 167 (refer to FIG. 22). In the automatic tool replacing method, a first length from one end E1 of the spindle 133 to the end of the new notch wheel N131 may be measured using the check sensor unit 167, and a position of the spindle 133 may be corrected using a second length from one end of the spindle 133 to the end of the existing notch wheel 0131, which is already known, and the first length.

The check sensor unit 167 may be a touch sensor, and when the notch processing device 130 moves downwardly to contact the end of the notch wheel N131, the notch processing device 130 may detect the contact and measure a mounting height of the new notch wheel N131. The controller 150 may compensate for a difference in height from the existing notch wheel 0131 based on the detected mounting height of the new notch wheel N131 using the position information, and then control the notch portion N to be processed. Through this, after automatically replacing the notch wheel, the notch processing device 130 maydirectly perform processing without separate teaching, thereby improving process efficiency.

Thereafter, referring to FIG. 23, the notch processing device 130 may move the spindle 133 in which the new notch wheel N131 is mounted to the notch portion N of the wafer and process the notch portion N so that a certain region of the notch portion N has a preset thickness.

The automatic tool replacing method described above may be performed by determining whether to replace the existing notch wheel 0131 at one end of the spindle 133. In other words, the automatic tool replacing method may determine whether to replace the existing notch wheel 0131 based on the preset number of processing, or may determine whether to replace by periodically identifying whether the existing notch wheel 0131 is abnormal.

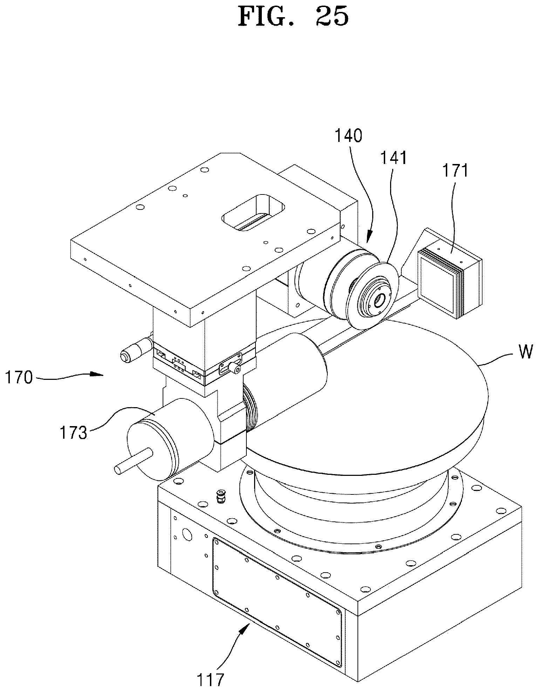

FIG. 25 is a diagram illustrating the inspection device 170 according to an embodiment of the present disclosure.

Referring to FIG. 25, the inspection device 170 performs a function of identifying a state of the notch wheel 131 or the edge wheel 141 before or after processing by the notch processing device 130 or the edge processing device 140. Hereinafter, for convenience of description, a case in which the inspection device 170 identifies the state of the edge processing device 140 as shown in the drawing is mainly described.

The inspection device 170 may include a light source unit 171 that emits light toward the edge wheel 141 and an imaging unit 173 located to face the light source unit 171 to image a state of the edge wheel 141.

The light source unit 171 may emit light to the edge wheel 141 of the edge processing device 140, and the imaging unit 173 may image light reflected from the edge wheel 141. The imaging unit 173 may be located to face the light source unit 171, and image light emitted to the edge wheel 141, and aportion corresponding to the edge wheel 141 may be covered by the edge wheel 141 and imaged to be dark, the rest may be imaged to be bright.

Through this, in an image obtained by the imaging unit 173, an edge of the edge wheel 141 may be detected by shade, and a state of the edge wheel 141 may be identified through the image. The wafer processing system 10 may determine whether to replace the edge wheel 141 according to the state of the edge wheel 141. The wafer processing system 10 may automatically replace the edge wheel 141 or notify an operator when the edge wheel 141 is worn or is abnormal.

As described above, in the wafer processing method according to an embodiment of the present disclosure, by processing the notch portion N of the wafer W before the back grinding process, damage to the wafer W occurring during the back grinding process may be prevented.

In addition, in the wafer processing method according to an embodiment of the present disclosure, by placing the center of the notch wheel 131 outside the wafer W during processing of the notch portion, stable and precise processing of the notch portion may be performed.

In addition, in the wafer processing method according to an embodiment of the present disclosure, recognition errors may be prevented by forming the inclined surface on the notch portion N of the wafer W and using the inclined surface as an alignment mark in a subsequent process.

As such, the present disclosure has been described with reference to an embodiment shown in the drawings, but this is only an example, and those skilled in the art may understand that various modifications and variations of the embodiment may be made therefrom. Therefore, the true technical scope of protection of the present disclosure should be determined by the technical spirit of the appended claims.

### Industrial Applicability

According to an embodiment of the present disclosure, the wafer processing method and system are provided. In addition, embodiments of the present disclosure may be applied to wafer processing including a notch portion.

## Claims

1. A wafer processing method comprising:
preparing a wafer having a notch portion at one side thereof;
aligning the wafer; and
processing the notch portion using a notch wheel so that a certain region of the notch portion has a preset thickness.

2. The wafer processing method of claim 1, further comprising:
analyzing image information of the notch portion and extracting edge information of the notch portion; and
setting a processing path of the notch wheel using the extracted edge information and previously planned notch processing information,
wherein, in the processing of the notch portion, the notch portion is processed so that the certain region of the notch portion has the preset thickness, by controlling the notch wheel to move the set processing path.

3. The wafer processing method of claim 1, further comprising:
before the processing of the notch portion, identifying whether an existing notch wheel is mounted at one end of a spindle;
when the existing notch wheel is mounted, removing the existing notch wheel by moving the spindle to a preset zone;
identifying whether the existing notch wheel is removed from the one end of the spindle; and
moving the spindle to a cassette unit storing a plurality of new notch wheels and mounting one of the plurality of new notch wheels at the one end of the spindle,
wherein, in the processing of the notch portion, the notch portion is processed so that the certain region of the notch portion has the preset thickness, by moving the spindle on which the new notch wheel is mounted to the notch portion of the wafer.

4. The wafer processing method of claim 1, further comprising:
before the processing of the notch portion, determining whether to replace the existing notch wheel at one end of the spindle;
when it is determined to replace the existing notch wheel, removing the existing notch wheel from the spindle and mounting a new notch wheel;
measuring a first length from one end of the spindle to an end of the new notch wheel by using a check sensor unit; and
correcting processing position information of the existing notch wheel using the first length,
wherein, in the processing of the notch portion, the notch portion is processed so that the certain region of the notch portion of the wafer has a preset thickness, by controlling the new notch wheel according to the corrected processing position information.

5. The wafer processing method of claim 1, further comprising:
supplying cleaning water by a wafer cleaning nozzle and cleaning the wafer,
wherein the wafer cleaning nozzle includes:
a first nozzle tip including a gas inlet and a gas outlet; and
a second nozzle tip including a cleaning water inlet and a cleaning water outlet,
wherein the gas outlet communicates with the cleaning water outlet.

6. A wafer processing system comprising:
a support table on which a wafer having a notch portion at one side thereof is seated;
an alignment device acquiring image information of the notch portion using a vision camera imaging the notch portion of the wafer seated on the support table and aligning the wafer by analyzing acquired image information of the notch portion; and
a notch processing device including a notch wheel processing the notch portion so that a certain region of the notch portion has a preset thickness and a spindle having one end at which the notch wheel is rotatably mounted.

7. The wafer processing system of claim 6, further comprising:
a controller extracting edge information of the notch portion by analyzing the image information of the notch portion, setting a processing path of the notch wheel using the extracted edge information and previously planned notch processing information, and controlling the notch wheel to move along the set processing path.

8. The wafer processing system of claim 6, further comprising:
an edge processing device including an edge wheel processing the portion of the wafer so that a certain region of the edge portion has a second thickness, and a second spindle having one end at which the edge wheel is mounted to be rotatable about a second rotation axis.

9. A wafer processing device comprising:
a notch wheel processing a notch portion of a wafer so that a certain region of the notch portion has a preset thickness; and
a spindle having one end at which the notch wheel is rotatably mounted.

10. The wafer processing device of claim 9, wherein
a diameter of the notch wheel is greater than a width of the certain region of the notch portion to be processed.

11. The wafer processing device of claim 9, wherein
the notch wheel includes a slit portion formed to divide a processing portion of the notch wheel including a processing surface in contact with the wafer into two or more parts.

12. The wafer processing device of claim 9, wherein
the notch wheel includes
a first processing portion having a first diameter and
a second processing portion having a second diameter smaller
than the first diameter, located at one end of the first processing portion, and protruding outwardly from one end of the first processing portion.

13. The wafer processing device of claim 12, wherein
the second processing portion has a tapered surface inclined with respect to one end surface of the first processing portion.
